# EUROPEAN PATENT APPLICATION

(11) **EP 1 605 520 A1**
(43) Date of publication of application: **14.12.2005**
(21) Application number: 05253554.9
(22) Date of filing: 09.06.2005
(51) Int. Cl.: H01L 31/0203, H01L 31/0232, H01L 27/146

(54) **Electronic imaging apparatus**

(30) Priority: 11.06.2004 JP 2004174740
(71) Applicant: CANON KABUSHIKI KAISHA, Ohta-ku, Tokyo (JP)
(72) Inventor: Nagano, Masatoshi Canon Kabushiki Kaisha, Tokyo (JP)
(74) Representative: Legg, Cyrus James Grahame

(57) **Abstract**

The imaging apparatus has a transparent member (1), a lens (2), support member (5), a photoelectric conversion device (16) and an electrical wiring board (12). The translucent member (1) is formed integrally with the photoelectric conversion device (16) via the support member (5), the lens (2) is formed on the translucent member (5) on the photoelectric conversion device side of the translucent member. The translucent member (1) adheres to the support member (5) with an adhesive agent (6). The lens (2) and the adhesive agent (6) do not come into contact. The apparatus further comprises an aperture module (9) and a light-shielding module (23).

## Description

### BACKGROUND OF THE INVENTION

### Field of the Invention

The present invention generally relates to an imaging apparatus and, in particular, but not exclusively to a compact imaging apparatus.

### Description of the Related Art

In recent years, compact imaging apparatuses including a photoelectric transducer, such as a CMOS (Complementary Metal-Oxide Semiconductor) sensor and a CCD (Charge-Coupled Device) sensor, incorporating a lens have been used for electronic apparatuses, such as cell phones and information terminal devices. However, demand has been growing for more compact imaging apparatuses as the sizes of the electronic apparatuses are reduced. Accordingly, packaging technology for an imaging apparatus including a CMOS sensor chip or a CCD sensor chip is becoming increasingly important today.

An imaging device having a packaging structure is disclosed in, for example, Japanese Patent No. 3207319. In this publication, a photoelectric transducer is connected to a wiring board by face-down bonding technique using an anisotropic conductive film, and an optical glass is disposed at a position on the opposite side of the wiring board from the photoelectric transducer. An imaging lens is attached to a sensor chip package having such a structure via a holding module so as to form an all-in-one imaging apparatus with a lens.

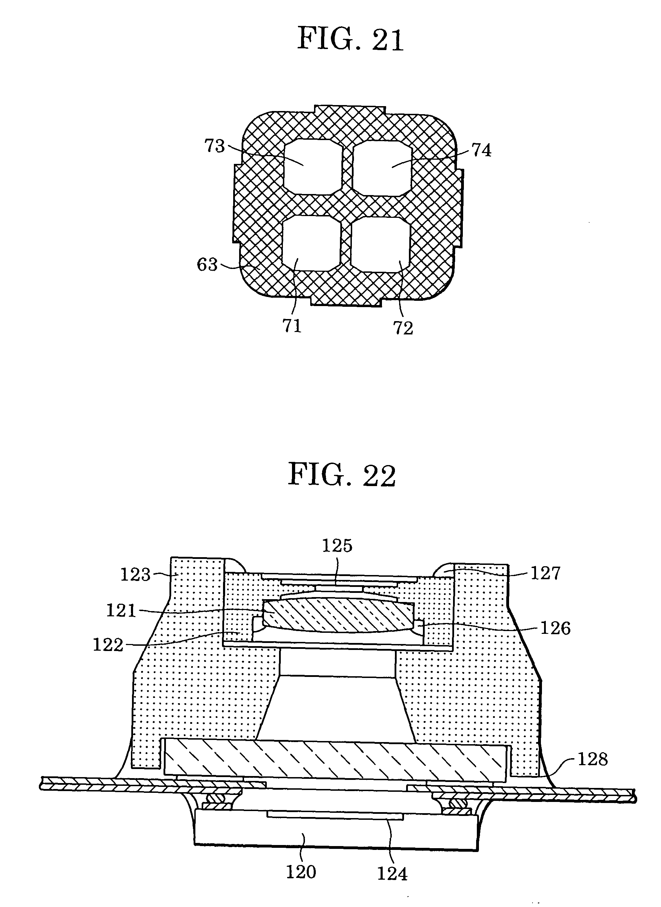

Fig. 22 illustrates a conventional all-in-one imaging apparatus in which a lens is integrated into an imaging device having such a package structure. The imaging apparatus includes a sensor chip package 120, an imaging lens 121, a lens barrel 122 for holding the imaging lens 121 with an adhesive agent 126, and an opening 125 for providing an aperture function. A holding module 123 holds a lens barrel 122. The holding module 123 is bonded to the sensor chip package 120 with an adhesive agent 128.

The lens barrel 122 is connected to the holding module 123 by a screw. By adjusting the position of the lens barrel 122 in its optical axis direction relative to the holding module 123, the focus on a photoelectric transducer 124 of the sensor chip package 120 can be adjusted. After focus adjustment, the lens barrel 122 is bonded to the holding module 123 with an adhesive agent 127.

However, the all-in-one imaging apparatus with a lens shown in Fig. 22 has:
(1) a large number of parts, thus resulting in a complicated manufacturing process and decreased productivity; and
(2) it is difficult to expose a light curing adhesive agent disposed inside to ultraviolet light, thus the light curing adhesive agent cannot be used.

### SUMMARY OF THE INVENTION

At least one exemplary embodiment provides an imaging apparatus having a compact and simple structure for achieving an increased quality image and/or an increased manufacturing productivity.

According to one embodiment of a first aspect of the present invention there is provided an imaging apparatus comprising: a transparent module, wherein the transparent module has a first surface, and a second surface opposite the first surface, the transparent module comprising a lens unit in a first region on the first surface; a holding module, wherein the holding module is configured to hold the transparent module, the holding module being bonded to a second region on the first surface of the transparent module with an adhesive agent, the second region being different from the first region; a photoelectric transducer, wherein the photoelectric transducer is configured to photoelectrically convert light passing through the transparent module; an aperture module, wherein the aperture module has an aperture opening, the aperture module being disposed in a third region on the second surface of the transparent module, the third region being opposite the first region; and a light-shielding module, wherein a portion of the light-shielding module is disposed in a fourth region on the second surface of the transparent module, the fourth region being situated opposite the second region.

According to a second aspect of the present invention there is provided an electronic apparatus comprising the above described imaging apparatus, and an electronic apparatus body including the imaging apparatus.

In another embodiment of the present invention there is provided an imaging apparatus comprising: a lens unit including at least one lens element; an imaging sensor chip connected to the lens unit, the imaging sensor chip including a light-receiving area; and a light shielding module connected to the lens unit and the imaging sensor chip, wherein a region between the lens unit and the imaging sensor chip is isolated from an external gaseous region.

According to a further aspect of the present invention there is provided a method of manufacturing an imaging apparatus, the method comprising: forming conductive foil patterns on a first side of an insulating sheet so as to form a wiring board; bonding a holding module to a second side of the insulating sheet, wherein the first side is opposite the second side; aligning the conductive foil patterns with conductive bumps provided on an imaging sensor chip; bonding the imaging sensor chip to the wiring board; inverting the bonded holding module, the wiring board and the imaging sensor chip; bonding a transparent module to the holding module, wherein the transparent module includes a lens unit; and sealing an internal region of the imaging apparatus, wherein the internal region includes a light receiving area of the imaging sensor chip.

Further features of exemplary embodiments will become apparent from the following description of examples of at least a few exemplary embodiments with reference to the attached drawings.

### BRIEF DESCRIPTION OF THE DRAWINGS

Fig. 1 illustrates the exterior of an electronic apparatus to which an imaging apparatus according to at least one exemplary embodiment can be applied.

Fig. 2 illustrates the exterior of another electronic apparatus to which the imaging apparatus according to at least one exemplary embodiment can be applied.

Fig. 3 illustrates a side sectional view of an imaging apparatus according to a first embodiment.

Figs. 4A and 4B illustrate a top view and a bottom view respectively of a transparent module according to the first embodiment.

Fig. 5 illustrates a perspective view of a holding module according to the first embodiment.

Fig. 6A illustrates a bottom view of a flexible wiring board shown in Fig. 3 according to the first embodiment; and Fig. 6B illustrates a top view of an imaging sensor chip shown in Fig. 3 according to the first embodiment.

Fig. 7 illustrates a manufacturing process of the imaging apparatus according to the first embodiment.

Fig. 8 illustrates a different view of a portion of the manufacturing process shown in Fig. 7.

Fig. 9 illustrates another different view of a portion of the manufacturing process shown in Fig. 7.

Fig. 10 illustrates a manufacturing process for electrical connection in accordance with at least one exemplary embodiment.

Fig. 11 illustrates a side sectional view of an imaging apparatus according to a second embodiment.

Figs. 12A and 12B illustrate a bottom view and a top view, respectively, of a transparent module according to the second embodiment.

Fig. 13 illustrates a top view of an imaging sensor chip according to the second embodiment.

Fig. 14 illustrates a bottom view of a holding module according to the second embodiment.

Fig. 15 illustrates a side sectional view of an imaging apparatus according to a third embodiment.

Fig. 16 illustrates a top view of a holding module in which a dust-proof glass is incorporated according to the third embodiment.

Fig. 17 illustrates an aperture module according to at least one exemplary embodiment.

Fig. 18 illustrates some of the manufacturing processes of the imaging apparatus according to the third embodiment.

Fig. 19 illustrates a side sectional view of an imaging apparatus according to a fourth embodiment.

Fig. 20 illustrates a plan view, viewed from the imaging sensor chip side, of a dust-proof glass (e.g. 56) according to the fourth embodiment.

Fig. 21 illustrates an aperture module according to at least one exemplary embodiment.

Fig. 22 illustrates a sectional view of a conventional compact imaging apparatus.

### DESCRIPTION OF THE EMBODIMENTS

The following description of at least one exemplary embodiment is merely illustrative in nature and is in no way intended to limit the invention, its application, or uses.

Processes, techniques, apparatus, and materials as known by one of ordinary skill in the art may not be discussed in detail but are intended to be part of the enabling description where appropriate. For example lens and lens units are discussed and any material that can be used to form lenses should fall within the scope of exemplary embodiments (e.g. glass, Si). Additionally the actual size of the lens may not be discussed however any size from macro lenses to micro and nano lenses are intended to lie within the scope of exemplary embodiments (e.g. lenses with diameters of nanometer size, micro size, centimeter, and meter sizes). Additionally exemplary embodiments are not limited to visual optical photographic systems, for example the system can be designed for use with infrared and other wavelengths photographic systems.

Examples of several exemplary embodiments are described below with reference to the accompanying drawings.

### First Embodiment

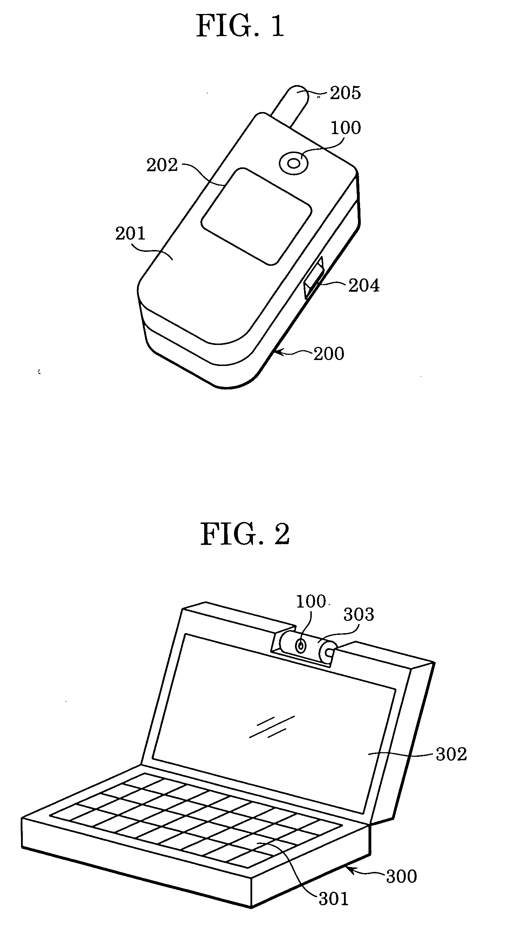

An electronic apparatus (e.g. cell phone, computer, camera, video projector, equivalents and other electronic apparatus as know by one of relevant skill in the arts) including an imaging apparatus according to a first embodiment is described next with reference to Fig. 1. Fig. 1 is a perspective view of the exterior of the electronic apparatus (e.g. cell phone). A main body 200 of the electronic apparatus includes a push button power switch 204 for turning on and off the electric power. A display unit 201 includes a display screen 202. The display unit 201 can be rotatably mounted on the main body 200. The display unit 201 further includes a communication device (not shown), a communication antenna 205, and an imaging apparatus 100.
The imaging apparatus 100 can be activated when the power switch 204 is turned on.

Thus, during a shooting operation, an image of a subject is formed on an imaging surface (not shown) of an imaging device in the imaging apparatus 100. The image of a subject output from the imaging device is displayed on the display screen 202.

Additionally, the imaging apparatus 100 according to this embodiment can be applied to any electronic apparatus, such as a personal computer (hereinafter simply referred to as a PC). Fig. 2 is a perspective view of the exterior of a notebook PC.

A main body 300 includes an operation unit (keyboard) 301 and a display unit 302 (e.g. liquid crystal). A rotating unit 303 is rotatably attached to a section (e.g. upper section) of the display unit 302. The rotating unit 303 can include the imaging apparatus 100. The rotating unit 303 facilitates a photographer to freely change a shooting direction. Accordingly, the photographer can take a picture of himself or herself.

By operating the operation unit 301, the photographer can instruct the imaging apparatus 100 to carry out a shooting operation. An image of a subject captured by the imaging apparatus 100 is displayed on the display unit 302. By operating the operation unit 301 again, the photographer can edit the captured image. Also, by connecting the PC to the Internet, the photographer can transmit the captured image to other people. An external remote-control unit (not shown) may be provided in addition to the operation unit 301 so that the photographer instructs the imaging apparatus 100 to carry out a shooting operation using this remote-control unit.

In addition, the rotating unit 303 may be applied to the electronic apparatus shown in Fig. 1 to change a shooting direction. The functions and mechanism provided to the imaging apparatus 100 are not limited to those described above. Alternatively, the functions and mechanism can be applied to personal digital assistants (PDAs) and fixed mount type electronic apparatuses (e.g. those without portability). An imaging apparatus according to this embodiment is described in detail below.

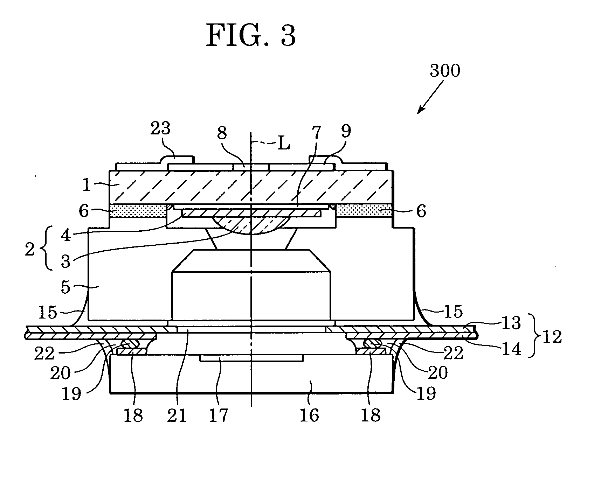

Fig. 3 illustrates a side sectional view of an imaging apparatus 300 according to the first embodiment.

The imaging apparatus includes a transparent module 1 (e.g. a flat glass substrate made from optical glass), and a lens unit 2 having an optical axis L. The lens unit 2 includes an aspheric section 3 and base section 4. The lens unit 2 can be easily formed by means such as a replica formation process. In general, the lens unit 2 is formed from a light-curable acrylate resin or a light-curable epoxy resin for the replica formation process. Additionally the lens unit 2 can be formed via known etching techniques (e.g. grayscale etching).

The imaging apparatus further includes a holding module 5 for holding the transparent module 1 on which the lens unit 2 is formed. The transparent module 1 can be bonded to the holding module 5 (e.g. with an adhesive agent 6). Additionally, an infrared-cut filter (layer) 7 can be formed on the transparent module 1 as a multilayer coating. The lens unit 2 can be disposed on the infrared-cut filter 7.

To improve the passage of visible light rays, the infrared-cut filter 7 can have a cutoff wavelength near 690 nm. The cutoff wavelength determines wavelengths of visible light rays that are passed and wavelengths of near infrared rays that are blocked. A short cutoff wavelength (e.g., 670 nm) reduces the light components having a wavelength shorter than or equal to 670 nm of light, and thus the color of a captured image in the periphery will become bluish compared to that in the center of the captured image. Therefore, in this embodiment the cutoff wavelength is determined to have a margin of about 40 nm from a wavelength of 650 nm (when the accuracy of the cutoff wavelength is considered, light components shorter than 670 nm are also cut). Additionally, if the value of the cutoff wavelength is shifted, the efficiency can vary. Accordingly, in this embodiment, the accuracy of the cutoff wavelength is determined as ±20 nm in order to maintain the decrease in efficiency within a predetermined range. In this embodiment, the cutoff wavelength can be in the range of 670±20 nm. Additional exemplary embodiments can have various other cutoff ranges, depending upon design criteria (e.g. for infrared optical systems) or no ranges (e.g. no filter 7).

An aperture module (layer) 9 having an opening 8 (e.g. circular, square, rectangular, ellipsoidal, equivalents and any other aperture shape and size as known by one of ordinary relevant skill in the art) is disposed on the surface (e.g. upper, or lower) of the transparent module 1. The aperture layer 9 can be easily and more accurately formed as an integral part of the transparent module 1 (e.g. by a screen printing method). To produce an aperture having an increased precision circular opening, an evaporation process, such as a photolithographic process, may be used. Additionally, in this embodiment, the infrared-cut filter 7 covers at least an area where the light rays from the opening 8 of the aperture layer 9 pass through.

A flexible wiring board (electric wiring board) 12 is composed of an insulating sheet 13, which is a base material, and a conductive foil (e.g. copper, equivalents and any other conductive layer as known by one of ordinary relevant skill in the art) pattern 14. In general, the insulating sheet 13 can be composed of any type of insulating material (e.g. polyimide, polyamide, and polyester, which are common base materials used for flexible printed wiring boards, equivalents and any insulating or semi-insulating material that could be used as known by one of ordinary relevant skill in the art). In yet a further exemplary embodiment, the insulating sheet 13 may be made from at least one of a phenolic resin, a glass-reinforced epoxy resin, a paper base material, and a glass base material, which are common base materials used for rigid printed wiring boards known as hard boards. The flexible wiring board 12 can be bonded to the holding module 5 (e.g. with an adhesive agent 15).

An imaging sensor chip (photoelectric transducer) 16 has a light-receiving area 17. A conductive bump 19 (e.g. gold, copper, and equivalents) is formed on an electrode pad 18 disposed in the periphery of the imaging sensor chip 16. The imaging sensor chip 16 is electrically connected to the flexible wiring board 12 via an adhesive 20 (e.g. anisotropic conductive paste).

An end-sealing material 22 can be used to seal the periphery of the imaging sensor chip 16 to reduce the surface deterioration (e.g. due to ambient air) of the imaging sensor chip 16. In this embodiment, the adhesive 20 reduces the ambient air entering the imaging apparatus 300. The end-sealing material 22 also reduces the ambient air penetration, which can increase the reliability. Also, the adhesive agent 6 and the adhesive agent 15 aid in sealing the imaging apparatus 300 in order to reduce the amount of ambient air entering the imaging apparatus 300.

A light shielding film (light shielding module) 23 is provided such that a part of the light shielding film 23 overlaps a fourth region, which is the periphery of the aperture layer 9. In this embodiment, the light shielding film 23 does not require the same precision as the opening 8 of the aperture layer 9, and thus the light shielding film 23 may be manufactured by a printing process (e.g. such as a pad printing process).

The light shielding film 23 reduces the amount of damaging rays from the periphery of the aperture layer 9 reaching the imaging sensor chip 16 so as to reduce the occurrence of ghosting and flare that deteriorates the image quality. Accordingly, a part of the inner periphery of the light shielding film 23 can overlap the outer periphery of the aperture layer 9 to reduce the occurrence of the damaging rays at the outer periphery of the aperture layer 9. That is, the light shielding film 23 and the aperture layer 9 can be integrated into the aperture of the imaging apparatus 300. Additionally, the light shielding film 23 may be formed by various techniques and material (e.g. bonding a material for the light shielding film in place or printing the light shielding film 23).

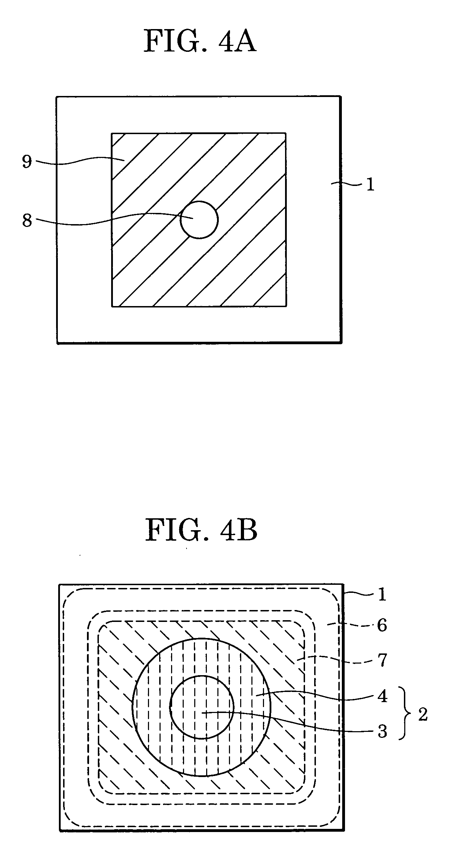

Fig. 4A is a top view of the lens unit 2, viewed through the transparent module 1 on which the aperture layer 9 is formed, and the infrared-cut filter 7. Fig. 4B is a bottom view of these components shown in Fig. 4A. As shown in Fig. 4B, the substantially circular aspheric section 3 and the substantially circular base section 4 of the lens unit 2 can be formed at substantially the center of the transparent module 1. Although in further exemplary embodiments the lens unit 2 can be formed off center (e.g. if there are multiple lens units). The area enclosed by dotted lines (a second region) is formed as an adhesive interface between the adhesive agent 6 and the transparent module 1 shown in Fig. 3 so as to surround the lens unit 2. Furthermore, in this embodiment, the adhesive agent 6 is formed so that the adhesive agent 6 is not in contact with the lens unit 2. This is because, if the adhesive agent 6 is in contact with the lens unit 2, the expansion or contraction of the adhesive agent 6 due to external environmental variation applies excessive stress to the lens unit 2.

Also, in this embodiment, the infrared-cut filter 7 is not disposed in the adhesive interface between the adhesive agent 6 and the transparent module 1, and the aperture layer 9 is not disposed on the upper surface of the transparent module 1 in an area corresponding to the adhesive interface (i.e., in the fourth region). This is because, as described below, the imaging apparatus 100 can be attached (e.g. by using the adhesive agent 6 of an ultraviolet curing type) where the attachment can become rigid in a short time when required. This facilitates the assembling of the imaging apparatus 100. If the infrared-cut filter 7 which passes few ultraviolet rays or the aperture layer 9 which blocks ultraviolet rays is disposed in the above-described area, the adhesive agent 6 cannot be sufficiently cured.

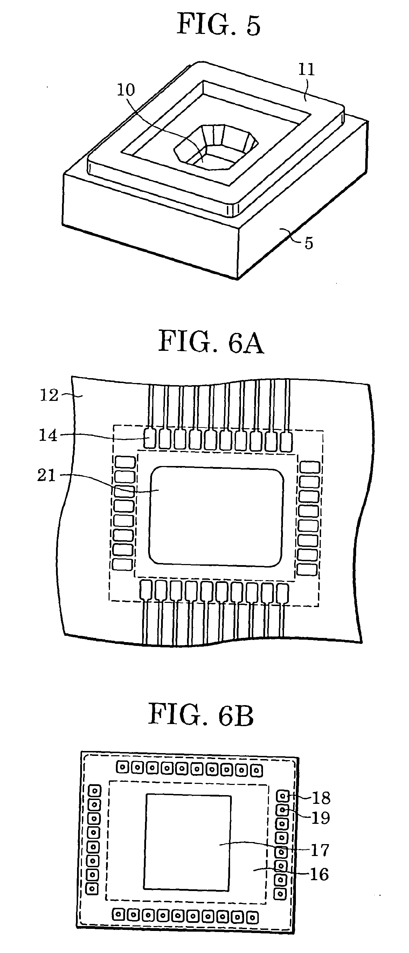

Fig. 5 illustrates a perspective view of the holding module 5. A through-hole 10 is formed at the center of the holding module 5 to allow the optical path of the lens unit 2 to pass therethrough. As shown in Fig. 5, the through-hole 10 can have a tapered shape from the lower side of the lens unit 2 to form a knife-edge structure, which, if present, reduces ghosting and flare to a minimum.

A ring-shaped raised portion 11 is formed on the upper surface of the holding module 5. The adhesive agent 6 is disposed on the raised portion 11. The widths of the raised portion 11 and the adhesive agent 6 (e.g. 28) can be designed so that the adhesive agent 6 is not in contact with the lens unit 2, as shown in Fig. 4B.

Fig. 6A illustrates a bottom view of the flexible wiring board 12 shown in Fig. 3. Fig. 6B illustrates a top view of the imaging sensor chip 16 shown in Fig. 3. A plurality of pixel units can be formed on the light-receiving area 17 of the imaging sensor chip 16. Each pixel unit can include a color filter, a micro lens, and a photoelectric transducer. In the color filter, a red pass filter, a blue pass filter, and two green pass filters can be arranged in Bayer array (not shown). As shown in Fig. 6A and 6B, the flexible wiring board 12 has an opening 21 at its center to allow the optical path of the lens unit 2 to pass through the flexible wiring board 12. In the vicinity of four sides of the opening 21, a plurality of the conductive foil patterns 14 can be formed.

On the other hand, a plurality of the electrode pads 18 can be disposed on the imaging sensor chip 16 at positions corresponding to the conductive foil patterns 14. On each electrode pad 18, the conductive bump 19 is formed. The conductive foil patterns 14 can be aligned with the conductive bumps 19 and can be electrically connected to the conductive bumps 19 with the adhesive 20. Here, among the conductive foil patterns 14 of the flexible wiring board 12, the conductive foil patterns 14 on only the upper and lower sides of the opening 21 are wired. However, by providing dummy conductive foil patterns and electrode pads on the right and left sides, the reliability of the electrical connection between the flexible wiring board 12 and the imaging sensor chip 16 can be increased.

As shown in Figs. 6A and 6B, the adhesive 20 (refer to Fig. 3) spreads over an area enclosed by dotted lines. This area surrounds the connection points of the conductive foil patterns 14 and the electrode pads 18. Accordingly, the adhesive 20 not only provides electrical connection between the conductive foil patterns 14 and the conductive bumps 19 but also fills gaps between the electrically connected conductive bumps 19 to reduce the amount of ambient air entering the inside.

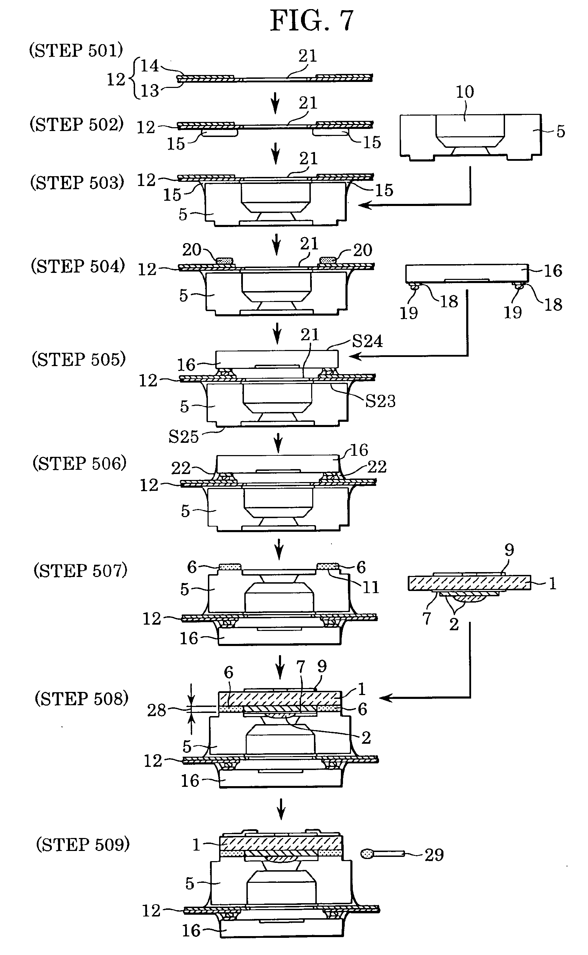

An exemplary embodiment of a manufacturing process of the imaging apparatus illustrated in the first embodiment is described next with reference to Fig. 7. In the manufacturing process according to this embodiment, a face-down manufacturing method is employed, in which the imaging apparatus shown in Fig. 3 is upside down.

Fig. 7 illustrates at least one exemplary embodiment of a manufacturing process of the imaging apparatus 300 shown in Fig. 3. First, the conductive foil patterns 14 can be formed on the insulating sheet 13 (e.g. by using a method such as etching) (step 501).

The adhesive agent 15 is disposed on the other side of the flexible wiring board 12 formed at step 501, namely, on a surface opposed to the surface on which the conductive foil patterns 14 are formed (e.g. by using a method such as screen printing) (step 502). The holding module 5 is then bonded to the flexible wiring board 12 with the adhesive agent 15 (step 503).

At step 503, an ultraviolet and heat curing adhesive agent can be used as the adhesive agent 15, although other types of bonding methods and adhesives can be used in other exemplary embodiments. When the holding module 5 is pressed against the flexible wiring board 12, the adhesive agent 15 normally sticks out into the opening 21 of the flexible wiring board 12. By irradiating the adhesive agent 15 with ultraviolet light through the through-hole 10 and the opening 21 in the vertical direction in advance, the adhesive agent 15 sticking out into the through-hole 10 and the opening 21 is blocked.

Thereafter, by placing the adhesive agent 15 in a high-temperature environment for a predetermined time period, the adhesive agent 15 can be entirely cured. Additionally, since, in at least one exemplary embodiment, the holding module 5 is bonded to the flexible wiring board 12 at high pressure, the thickness of the adhesive agent 15, in such an exemplary embodiment, between the holding module 5 and the flexible wiring board 12 can be a few micrometers.

Subsequently, the adhesive 20 can be disposed (e.g. by screen printing, equivalents, and other known deposition methods as known by one of relevant skill) on the flexible wiring board 12 (step 504). In place of the adhesive 20, a frame anisotropic conductive film may be disposed on the flexible wiring board 12.

After the connecting points of the conductive foil patterns 14 of the flexible wiring board 12 are aligned with the conductive bumps 19 formed on the imaging sensor chip 16, the flexible wiring board 12 is bonded to the imaging sensor chip 16 with the adhesive 20 (step 505). The connection (e.g. by using the adhesive 20) can be carried out under increased temperature and pressure conditions. Accordingly, in a surface s23 of the holding module 5 on the flexible wiring board 12 side, an area (e.g. a flat area) can overlap the area where the adhesive 20 is formed. For example, in at least one exemplary embodiment the surface s23 can be flat, and thus the entire surface s23 is formed as a flat plane except for the through-hole 10.

When the pressure is increased, a surface s24 of the imaging sensor chip 16 presses operatively against a surface s25 of the holding module 5 on the transparent module 1 side by a tool, such as a jig. Accordingly, in at least one exemplary embodiment there can be some flat area on the surface s25 of the holding module 5.

In this embodiment, the upper surface of the raised portion 11 shown in Fig. 5 corresponds to the surface s25.
In at least one exemplary embodiment, the surface s25 substantially overlaps the area where the adhesive 20 is formed in a plane perpendicular to the optical axis L. Thus, deformation of the holding module 5 occurring when the pressure is increased can be reduced, and therefore, the rate of successful connection with the adhesive 20 can be increased. Additionally, the adhesive 20 (e.g. partially conductive epoxy resin, for example in at least one exemplary embodiment, the adhesive 20 is made from an epoxy resin mixed with about 3 to 30 percent conductive particles having a diameter of about 1 to 10 µm).

Thereafter, the end-sealing material 22 can be cured by applying heat (e.g. shining ultraviolet light on the end-sealing material 22), while covering the adhesive 20 (step 506).

Alternatively, after the flexible wiring board 12 is connected to the imaging sensor chip 16 by the adhesive 20, the transparent module 1 may be bonded to the flexible wiring board 12 with the adhesive agent 15.

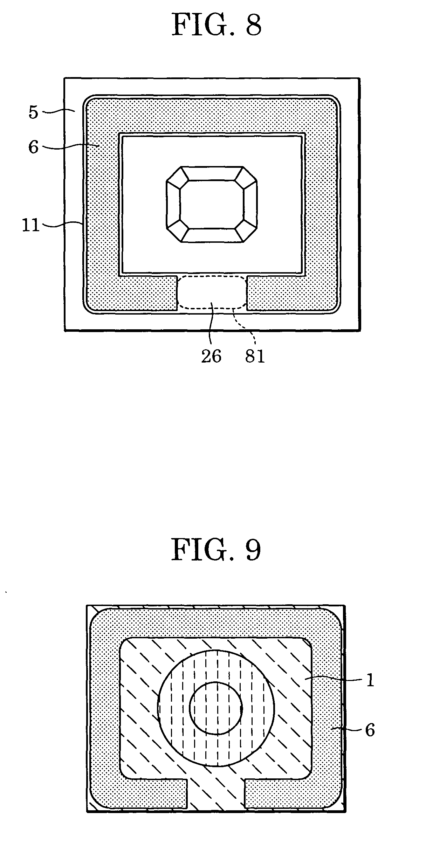

Subsequently, the whole imaging apparatus is turned upside down. The adhesive agent 6 is then disposed on the raised portion 11 of the holding module 5 (step 507). Fig. 8 illustrates the adhesive agent 6 applied to the raised portion 11 of the holding module 5 viewed from the top of the imaging apparatus at step 507 in Fig. 7.

The adhesive agent 6 is disposed on (applied to) the ring-shaped raised portion 11 (e.g. by a screen printing method or a dispenser method). At that time, a discontinuity 26 (Fig. 8) is formed at one part of the adhesive agent 6. This is because if, at step 508, which is a bonding step of a transparent module, as described below, the adhesive agent 6 has no discontinuity 26 to release air trapped inside the imaging apparatus and if the trapped air expands due to the increased heat, the adhesive agent 6 possibly breaks at an unexpected portion, and therefore, the air leaks from that portion. The adhesive agent 6 can be made of many types of adhesive agents (e.g. made from an ultraviolet curing epoxy adhesive agent).

The transparent module 1 is then bonded to the holding module 5 (step 508). The lens unit 2, the infrared-cut filter 7, and the aperture layer 9 can be formed on the transparent module 1 in advance. The transparent module 1 can be chucked by a chucking tool, such as a jig. The focus and tilt adjustment for the lens unit 2 is then carried out. After the position of the transparent module 1 is determined, ultraviolet light is emitted, from an aperture forming side of the transparent module 1, to cure the adhesive agent 6. After the adhesive agent 6 is cured, the chucking by the jig is stopped to release the transparent module 1.

The ultraviolet light passes through the areas (the second and fourth regions) of the transparent module 1 to irradiate the adhesive agent 6. At that time, in the example discussed herein, the aperture layer 9 and the infrared-cut filter 7 are not formed on the upper surface and lower surfaces of the areas, however, in other exemplary embodiments they could be so formed. Therefore, the ultraviolet light emitted from the aperture forming side of the transparent module 1 passes through the transparent module 1 with minimum attenuation so as to cure the adhesive agent 6. The thickness of the adhesive agent 6 can be at a reduced level that facilitates the above-described adjustment to lie within the range, which includes dimensional tolerances and assembly errors. This maintains the position of the lens unit 2 relative to the imaging sensor chip 16 constant even when the adhesive agent 6 expands or contracts due to environmental changes. Depending upon final composition, the adhesive agent 6 can expand or contract more than other components.

The focus and tilt adjustment for the lens unit 2 can be easily carried out by focusing a predetermined chart on the imaging sensor chip 16 (e.g. by using the lens unit 2) and reading out an image signal of the chart from the imaging sensor chip 16. At step 508, the flexible wiring board 12 has already been electrically connected to the imaging sensor chip 16. Accordingly, the image signal can be read out via the flexible wiring board 12.

Additionally, the focus and tilt adjustment for the lens unit 2 is carried out while the uncured adhesive agent 6 is sandwiched between the transparent module 1 and the holding module 5. At that time, since the transparent module 1 needs to move slightly, the viscosity and wettability of the adhesive agent 6 can be a factor. Here, in general, the viscosity of an adhesive agent can be changed by changing the composition ratios and type of filler. Accordingly, the viscosity of the adhesive agent 6, deposited on the transparent module 1 and the holding module 5, can be changed to a predetermined value in accordance with the properties of the transparent module 1 and the holding module 5.

Finally, the discontinuity 26 of the adhesive agent 6, as shown in Fig. 8, is filled with an adhesive agent 81, which is then cured. Thus, the entire periphery of the raised portion 11 is sealed by the adhesive agent. The light shielding film 23 can then disposed at the periphery of the aperture layer 9 (the fourth region) so that the light shielding film 23 overlaps a portion of the aperture layer 9. As a result, the imaging apparatus is achieved (step 509). As shown in Fig. 7, a nozzle 29 of a dispenser gets close to the side of the raised portion 11 and applies the adhesive agent to the entire periphery of the raised portion 11 so as to seal it. The thickness 28 of the adhesive agent (i.e., the gap of the discontinuity 26) is small, and therefore, the adhesive agent can easily enter the inside of the gap by capillary filling. The adhesive agent used for sealing may be the same material as the adhesive agent 6.

Since the above-described manufacturing process uses the imaging sensor chip 16, which is a semiconductor product, the imaging apparatus is manufactured in a clean room. Although a face-down manufacturing method is not employed at steps 507 to 509, a face-down manufacturing method can be employed if the adhesive agent 6 is formed on the transparent module 1 side, as shown in Fig. 9.

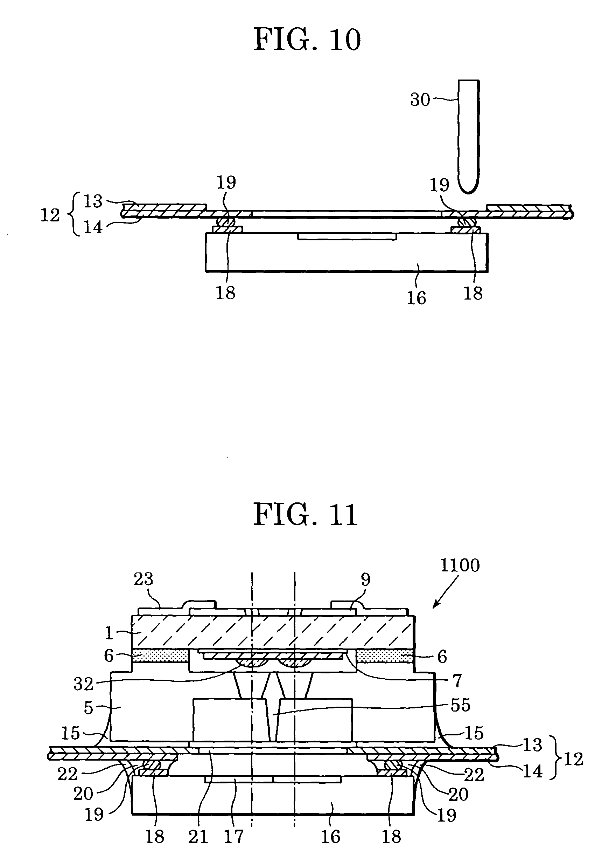

In this embodiment, the flexible wiring board 12 is electrically connected to the imaging sensor chip 16 (e.g. by using the adhesive 20). As shown in Fig. 10, the conductive foil patterns 14 of the flexible wiring board 12 may be electrically connected to the conductive bumps 19 formed on the electrode pads 18 of the imaging sensor chip 16 (e.g. by using a compact bonding heater tool 30) so that the conductive foil patterns 14 can be connected to the conductive bumps 19 for each pin (e.g. by supersonic thermal bonding). In this case, in the processes shown in Fig. 7, the assembly process of the holding module 5 is exchanged with the assembly process of the imaging sensor chip 16 in order.

The gaps between the conductive bumps 19 can be filled with the end-sealing material 22. As shown in the drawing, the flexible wiring board 12 can have a structure in which the conductive foil patterns 14 extend beyond the insulating sheet 13 towards the opening 21. This structure is known as a lead frame structure. Therefore, the holding module 5 should be an insulating material when the holding module 5 is bonded and operatively connected to the flexible wiring board 12. If a material having even a small conductivity is used for the holding module 5, another insulating sheet can be used on a surface of the holding module 5 on the flexible wiring board 12 side to reduce the possibility of the conductive foil patterns 14 from being in contact with the holding module 5. However, this manufacturing process reduces the need for the face-down manufacturing method. Furthermore, since a tack weld time for connecting one pin is a few seconds, in the case of a small number of electrode pads, the total tack weld time can be reduced compared to a method using the adhesive 20.

Thus, this embodiment facilitates the manufacturing (e.g. by using a light curing adhesive agent) and/or provides an imaging apparatus producing an increased quality image.

That is, this embodiment provides a structure in which the transparent module 1 includes: the lens unit 2; supported by the holding module 5, which also supports aperture layer 9; and the infrared-cut filter 7 that transmits little ultraviolet light, where the aperture layer 9 that transmits no ultraviolet light and is disposed at an area where the adhesive agent 6 is not disposed (i.e., the second and fourth regions). Accordingly, since the adhesive agent 6 can be irradiated with sufficient ultraviolet light to be cured in a short time during assembling, this embodiment facilitates the assembling of the imaging apparatus.

Furthermore, after the adhesive agent 6 is cured, the light shielding film 23 is disposed in the fourth region to form an aperture in which the light shielding film 23 and the aperture layer 9 are integrated. Accordingly, the amount of unwanted light (damaging light) from the periphery of the aperture layer 9, reaching the imaging sensor chip 16, is reduced. This reduces the occurrence of ghosting and flare that deteriorates the image quality.

In particular, in this embodiment, the aperture layer 9 and the light shielding film 23 are disposed (formed) by the above-described printing and/or evaporation methods. Thus, the productivity can be further increased.

Additionally, the transparent module 1, on which the lens unit 2 is disposed, can be bonded to the holding module 5 by a light curing adhesive agent. This facilitates focus and tilt adjustment of the lens unit 2 to be carried out while sandwiching the uncured adhesive agent 6. After the adjustment, the adhesive agent 6 can be cured by being irradiated with ultraviolet light. This facilitates the adjustment and does not increase the number of parts even though this adjustment is included in the manufacturing process.

Furthermore, since the lens unit 2 is directly disposed (formed) on the transparent module 1, the total optical length can be reduced. As a result, the size of the imaging apparatus can be reduced. Also, an environmentally-friendly imaging apparatus can be achieved because the number of parts in the apparatus can be reduced.

Although the lens unit 2 is made from resin in this exemplary embodiment, the lens unit 2 is disposed on the transparent module 1, which can be made from an optical glass, serving as a base module. Since the volume of the transparent module 1 is significantly larger compared to the lens unit 2, the properties of the transparent module 1 can dominate the coefficient of linear expansion. Accordingly, the precise position and shape of the aspheric section 3 remain unchanged even when the ambient conditions change.

### Second Embodiment

A second embodiment, of an imaging apparatus 1100 includes a compound eye lens 32. Such an imaging apparatus 1100 can includes optical systems for each color. By combining a captured image for each color, a color image is constructed. This imaging apparatus 1100 improves qualities since its focal length is substantially half that of a normal optical system. Therefore, by applying this embodiment, a more compact imaging apparatus can be achieved.

In this embodiment, components identical to those in the first embodiment are designated by identical reference numerals, and therefore, identical structures are described with reference to figures illustrated and described in the first embodiment.

Fig. 11 illustrates a side sectional view of an imaging apparatus according to the second embodiment. A lens unit 32 including a four-compound eye lens is disposed on the transparent module 1, each lenslet of the four-compound eye lens focuses an independent color light. In the sectional view of Fig. 11, only two compound eye lenses among four compound eye lenses are shown. Note that the discussion amongst examples is not intended to be limitative, for example of the number of items (e.g. at least one exemplary embodiment can have more than four lenses).

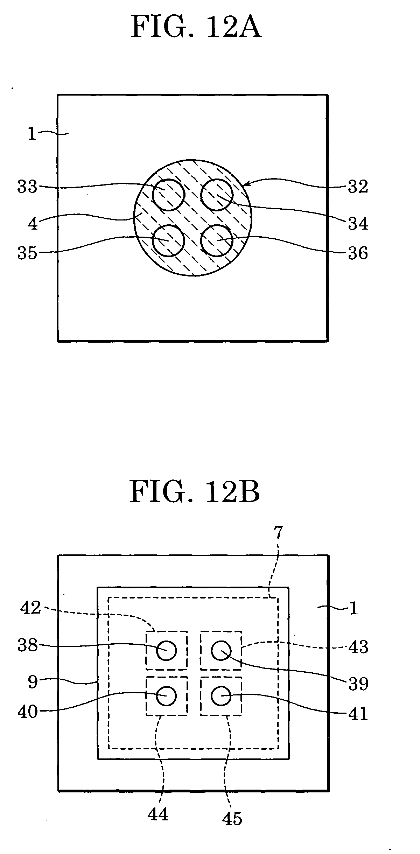

Fig. 12A illustrates a bottom view of the transparent module 1. The lens unit 32 is bonded to the bottom surface of the transparent module 1. The lens unit 32 includes four lens sections, namely, the aspheric sections 33, 34, 35, and 36 on a base section 4. For example, the aspheric section 33 is associated with red light. The aspheric sections 34 and 35 are associated with green light, and the aspheric section 36 is associated with blue light. Each aspheric section has an aspheric shape optimized for the transmission wavelength of the corresponding color.

An aperture module (layer) 9 is disposed (formed) on the top surface of the transparent module 1. In four openings (aperture openings) 38, 39, 40, and 41 formed in the aperture layer 9, color filters 42, 43, 44, and 45 corresponding to the lens sections of the lens unit 32 are disposed, respectively. Additionally, an infrared-cut filter 7 can be disposed (formed) between the bottom surface of the transparent module 1 and the lens unit 32. In this exemplary embodiment, the infrared-cut filter 7 covers at least an area where the light rays from the aperture layer 9 pass through.

As in the first embodiment, the infrared-cut filter 7 is not formed in an adhesive interface between an adhesive agent 6 and the transparent module 1. The aperture layer 9 is not formed on the top surface of the transparent module 1 in the area corresponding to the adhesive interface.

Fig. 12B illustrates a top view of the transparent module 1 illustrating a positional relationship among the four openings 38, 39, 40, and 41 of the aperture layer 9 corresponding to the lens unit 32 having four compound eye lenses. The color filters 42, 43, 44, and 45 can be formed in the openings 38, 39, 40, and 41. Here, the aspheric section 33 corresponds to the opening 39 and the color filter 43. The aspheric section 34 corresponds to the opening 38 and the color filter 42. The aspheric section 35 corresponds to the opening 41 and the color filter 45. The aspheric section 36 corresponds to the opening 40 and the color filter 44.

In this embodiment, the color filters 42, 43, 44, and 45 are disposed on the transparent module 1 side. In at least one exemplary embodiment, the color filters 42, 43, 44, and 45 are not required under a micro lens of the imaging sensor chip 16. This facilitates the micro lens to be arranged closer to a light receiving unit. Thus, in such an exemplary embodiment, a light receiving area of the micro lens can be expanded.

The color filters 42, 43, 44, and 45 can be manufactured (e.g. by using a photolithography (evaporation) method, which can be used for manufacturing color filters of a CCD (Charge-Coupled Device)). In addition, these color filters can be produced by a printing method.

Furthermore, in this embodiment, the color filters 42, 43, 44, and 45 and the aperture layer 9 can be formed on the top surface of the transparent module 1, while the infrared-cut filter 7 is formed on the bottom surface of the transparent module 1. However, at least one exemplary embodiment is not limited thereto. For example, the infrared-cut filter 7 may be formed on the top surface of the transparent module 1 along with the color filters 42, 43, 44, and 45 and the aperture layer 9. Also, the forming order of the layers may be changed.

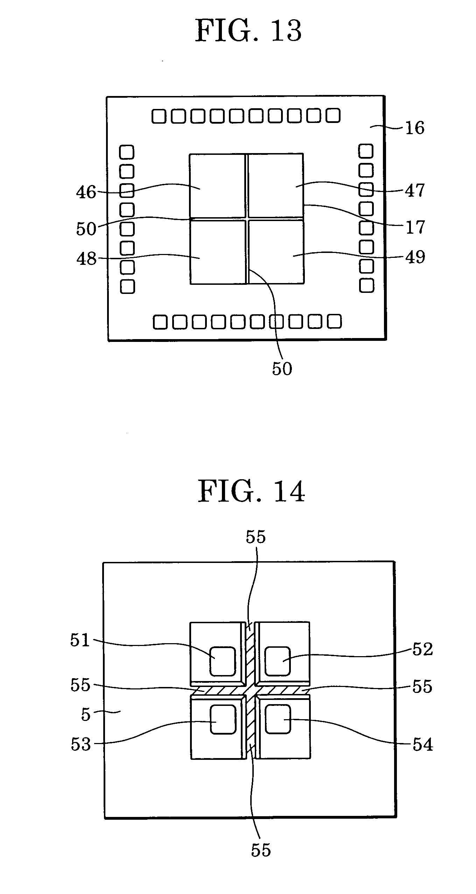

Fig. 13 illustrates a top view of the imaging sensor chip 16 according to this embodiment. A light-receiving area 17 includes four light receiving regions 46, 47, 48, and 49, which correspond to the lens unit 32 having four compound eye lenses. The receiving regions can be arranged with small gaps, 50 therebetween. The aspheric section 33 corresponds to the light receiving region 47. The aspheric section 34 corresponds to the light receiving region 46. The aspheric section 35 corresponds to the light receiving region 49. The aspheric section 36 corresponds to the light receiving region 48.

Fig. 14 illustrates a bottom view of a holding module 5. The holding module 5 includes four through-holes 51, 52, 53, and 54, which correspond to the lens unit 32 having four compound eye lenses. As shown in Fig. 14, the through-holes are separated by a thin wall 55. The wall 55 reduces the light crosstalk, in which light rays passing through the aspheric section 33 of the lens unit 32 leak into the adjacent light receiving regions 46 and 49. The bottom surface of the wall 55 (an area with hatching in Fig. 14) corresponds to the gap 50 of the imaging sensor chip 16.

As shown by a cross section of the wall 55 in Fig. 11, the wall 55 has two tapered sections (upper and lower tapered sections) to reduce ghosting, flare, and light crosstalk. Also, the two tapered sections provide mechanical strength.

Accordingly, the second embodiment can provide a more compact imaging apparatus compared to the first embodiment while providing similar characteristics. The manufacturing process can be identical to that in the first embodiment, and therefore, the description is not repeated here.

As in the first embodiment, the unit of the flexible wiring board 12 and the imaging sensor chip 16, as described in relation to Fig. 10, can be used in the second embodiment.

### Third Embodiment

In a third embodiment, a dust-proof glass (another transparent module) for packaging, as shown in the example, is attached to the imaging apparatus 300 in the first embodiment. Accordingly, not all of the manufacturing processes require a clean room. The manufacturing processes can be divided into two types: processes in a clean room and processes under normal conditions. This embodiment reduces the need for a clean room, which requires a large amount of facility investment.

In this embodiment, components identical to those in the first and second embodiments are designated by identical reference numerals, and therefore, identical structures are described with reference to figures illustrated and described in the first and second embodiments.

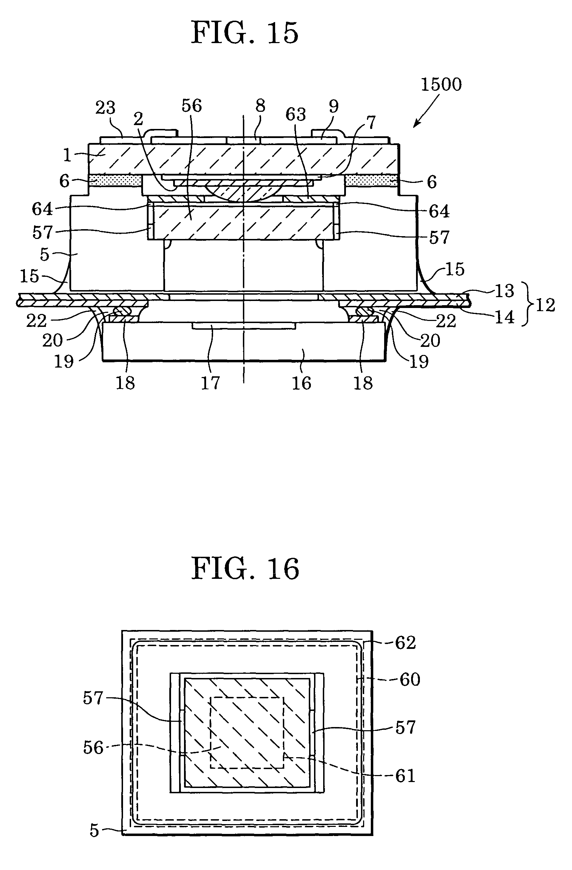

Fig. 15 illustrates a side sectional view of an imaging apparatus 1500 according to the third embodiment. A holding module 5 supports a dust-proof glass 56 (another transparent module), which protects the imaging sensor chip 16 against dust depositing on the imaging sensor chip 16. The dust-proof glass 56 can be bonded and operatively connected to the holding module 5 (e.g. with an adhesive agent 57).

Fig. 16 illustrates a top view of the holding module 5 in which the dust-proof glass 56 is incorporated. Two portions of the dust-proof glass 56 can be bonded to the holding module 5 with a minimum amount of the adhesive agent 57 (e.g. which can be an ultraviolet curing adhesive agent or a heat curing adhesive agent).

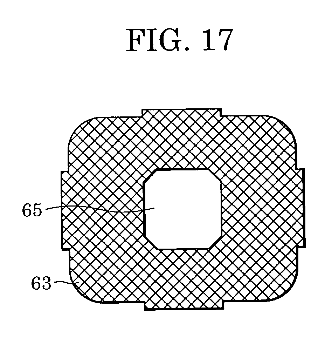

Fig. 17 illustrates a top view of an aperture module 63 (a second aperture module). The aperture module 63 reduces the amount of light incident on a light-receiving area from an area of the transparent module 1 where the aperture layer 9 is not formed. This reduces the occurrence of flare and ghosting. The aperture module 63 includes an opening (aperture opening) 65 corresponding to light rays from the lens unit 2. A heat curing adhesive agent can be used as the adhesive agent 64. The aperture module 63 may be formed on the top surface of the dust-proof glass 56 by a printing method or a photolithography method.

In Fig. 16, a square 60 shown by a dotted line indicates an external shape of the imaging sensor chip 16. A square 61 shown by a dotted line indicates a light-receiving area 17. As can be seen, the external shape of the dust-proof glass 56 can be slightly larger than the light-receiving area 17 and can be smaller than the external shape of the imaging sensor chip 16. A square 62 shown by a dotted line indicates the external shape of the transparent module 1, which can be larger than the external shape of the dust-proof glass 56.

The tabular aperture module 63 can be disposed on the top surface of the dust-proof glass 56. The aperture module 63 can be bonded and operatively connected to the holding module 5 (e.g. fixed with the adhesive agent 64).

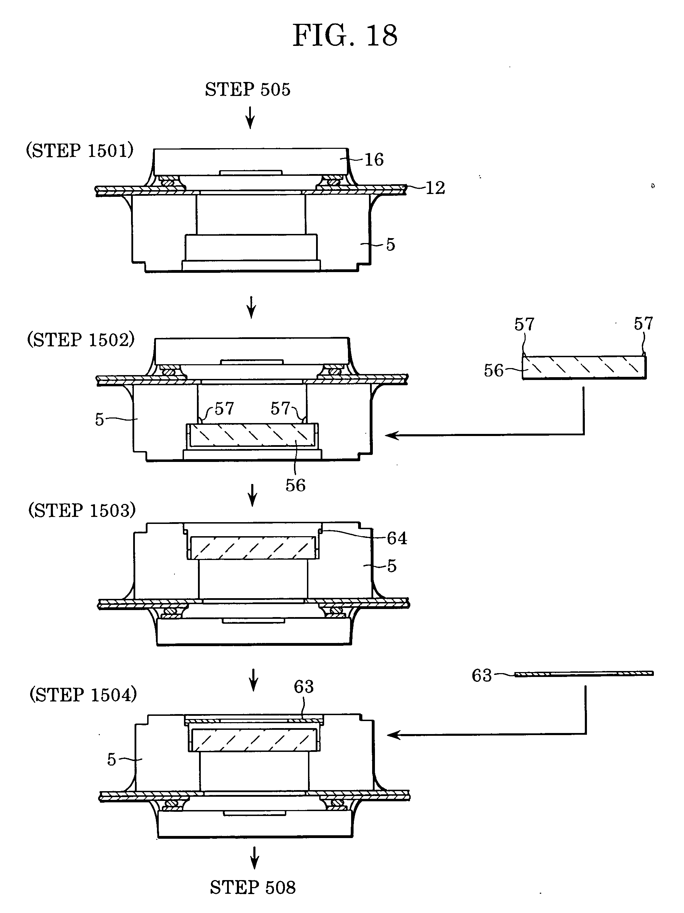

A manufacturing process according to the third embodiment is described next with reference to Fig. 18. In this manufacturing process, steps 501 to 506 in Fig. 7 are carried out as in the first embodiment, and therefore, descriptions are not repeated.

Step 1501 corresponds to step 506 in Fig. 7, where the holding module 5, the flexible wiring board 12, and the imaging sensor chip 16 are assembled.

At step 1502, the dust-proof glass 56 is bonded and operatively connected to the holding module 5. The adhesive agent 57 is applied to a surface of the dust-proof glass 56 on the imaging sensor chip side in advance by a screen printing method or a dispenser method. The dust-proof glass 56 is then pressed against the holding module 5 (e.g. by using a tool like a jig). When an ultraviolet curing adhesive agent is used, ultraviolet light is emitted from the bottom in the drawing to cure the adhesive agent 57.

The above-described processes require operations in a clean room. After step 1503, the operations are carried out under normal conditions.

At step 1503, the adhesive agent 64 is applied to the holding module 5 by a dispenser. The adhesive agent 64 is used for bonding the aperture module 63 at the subsequent step.

At step 1504, the aperture module 63 is pressed against the holding module 5 by a tool like a jig to bond and fix the aperture module 63 to the holding module 5. At that time, since the aperture module 63 is a light shielding material, it is difficult to cure the aperture module 63 by ultraviolet light. Accordingly, as described above, a heat curing adhesive agent can be used as the adhesive agent 64. The process then proceeds to the subsequent step. However, the subsequent steps can be identical to steps 508 and 509 in Fig. 7, and therefore, descriptions are not repeated.

By carrying out the above-described processes, the imaging apparatus 1500 according to the third embodiment can be manufactured. In the third embodiment, the number of steps carried out in a clean room is reduced compared to that in the first embodiment. The amount of facility investment can be decreased. Accordingly, the size and manufacturing cost of the imaging apparatus can be further reduced while providing similar characteristics as in the first and second embodiments. In addition, as in the first embodiment, the unit of the flexible wiring board 12 and the imaging sensor chip 16, as described in relation to Fig. 10, can be used in the third embodiment.

### Fourth Embodiment

In a fourth embodiment, the structure (e.g. by using the dust-proof glass 56 described in the third embodiment) is applied to an imaging apparatus 1900 including the lens unit 32 having a four-compound eye lens unit (e.g. as in the second embodiment).

In this embodiment, components identical to those in the first to third embodiments are designated by identical reference numerals, and therefore, identical structures are described with reference to figures illustrated and described in the first to third embodiments.

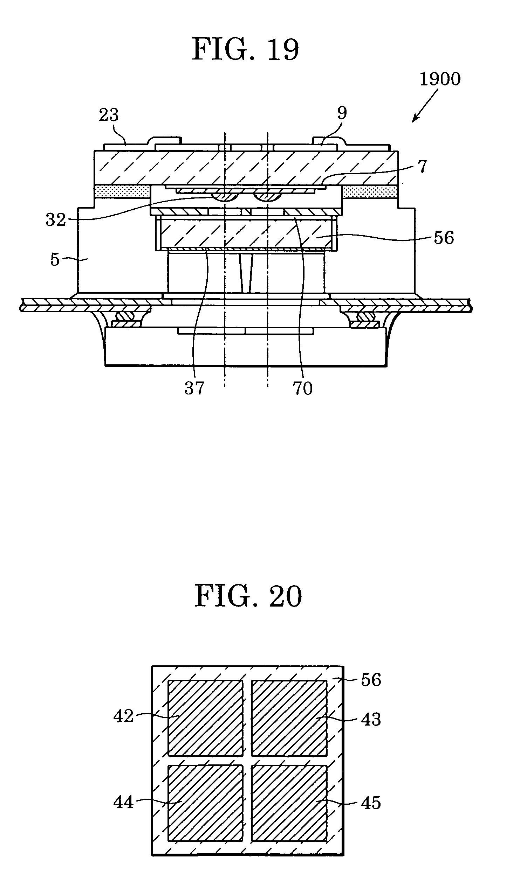

Fig. 19 illustrates a side sectional view of an imaging apparatus according to the fourth embodiment. A dust-proof glass 56 and an aperture module 63 can be bonded and operatively connected to the holding module 5. In this embodiment, a color filter layer 37 is disposed on a surface of the dust-proof glass 56 on the imaging sensor chip 16 side. Accordingly, only the lens unit 32 having four compound eye lenses, the infrared-cut filter 7, and the aperture layer 9 can be formed on the transparent module 1.

Fig. 20 illustrates a plan view, viewed from the imaging sensor chip 16 side, of the dust-proof glass 56. The dust-proof glass 56 includes filter units 42, 43, 44, and 45 for individual colors. In this embodiment, nothing is formed on the top side of a color filter layer 37. That is, a color filter layer is formed on the bottom side of the dust-proof glass 56. Therefore, since, in this particular example, a planarizing process is not required, the manufacturing cost can be reduced.

Fig. 21 illustrates a top view of the aperture module 63. On the aperture module 63, four openings (aperture openings) 71, 72, 73, and 74 are formed. Note that the discussion herein with respect to examples is not intended to limit the shape and number of items that fall with in the scope of at least one exemplary embodiment (e.g. there could be multiple aperture openings). The four openings 71, 72, 73, and 74 correspond to the four aspheric sections 33, 34, 34, and 35 of the lens unit 32, as shown in Fig. 12A.

The above-described structure is illustrative of the fourth embodiment. The other components and structures can be identical to those in other embodiments, and therefore, descriptions are not repeated. Also, the manufacturing process is identical to that in the third embodiment, and therefore, the description is not repeated. In addition, as in the first embodiment, the unit of the flexible wiring board 12 and the imaging sensor chip 16, as described in relation to Fig. 10, can be used in the fourth embodiment.

As described above, in the imaging apparatus according to the fourth embodiment, the color filter layer 37 is formed on the dust-proof glass 56. Consequently, the manufacturing cost can be significantly reduced while providing the similar characteristics as in the above-described embodiments.

The above-described embodiments can provide an imaging apparatus for producing an increased quality image by reducing the amount of unnecessary light from being incident on a photoelectric transducer (e.g. by using a light-shielding member). The imaging apparatus can be easily attached (e.g. by using a light curing adhesive agent), and therefore, the imaging apparatus can provide increased productivity.

While at least a few exemplary embodiments have been described, it is to be understood that exemplary embodiments are not limited to the disclosed examples. On the contrary, at least one exemplary embodiment is intended to cover various modifications and arrangements included within the spirit and scope of the appended claims, specification, figures, equivalents, and knowledge by one of relevant skill. The scope of the following claims is to be accorded the broadest interpretation so as to encompass all such modifications and equivalent structures and functions.

## Claims

1. An imaging apparatus comprising:
a transparent module, wherein the transparent module has a first surface, and a second surface opposite the first surface, the transparent module comprising a lens unit in a first region on the first surface;
a holding module, wherein the holding module is configured to hold the transparent module, the holding module being bonded to a second region on the first surface of the transparent module with an adhesive agent, the second region being different from the first region;
a photoelectric transducer, wherein the photoelectric transducer is configured to photoelectrically convert light passing through the transparent module;
an aperture module, wherein the aperture module has an aperture opening, the aperture module being disposed in a third region on the second surface of the transparent module, the third region being opposite the first region; and
a light-shielding module, wherein a portion of the light-shielding module is disposed in a fourth region on the second surface of the transparent module, the fourth region being situated opposite the second region.

2. The imaging apparatus according to Claim 1, wherein the holding module is bonded to the second region via a light curing adhesive agent.

3. The imaging apparatus according to Claim 1, wherein the aperture module is disposed on the second surface by using one of an evaporation method and a printing method.

4. The imaging apparatus according to Claim 1, wherein the light-shielding module is disposed on the second surface by using one of a printing method and a bonding method.

5. The imaging apparatus according to Claim 1, wherein the first surface of the transparent module is disposed nearer the photoelectric transducer than the second surface.

6. The imaging apparatus according to Claim 1, wherein the lens unit comprises a plurality of lens elements and the aperture module has a plurality of aperture openings.

7. The imaging apparatus according to Claim 1, further comprising an electrical wiring board disposed between the holding module and the photoelectric transducer.

8. An electronic apparatus comprising:
the imaging apparatus according to any of Claims 1 to 7; and
an electronic apparatus body including the imaging apparatus.

9. The imaging apparatus according to Claim 1, further comprising:
a second transparent module, and
a second aperture module, wherein the second aperture module is disposed between the second transparent module and the lens unit.

10. An imaging apparatus comprising:
a lens unit including at least one lens element;
an imaging sensor chip connected to the lens unit, the imaging sensor chip including a light-receiving area;and
a light shielding module connected to the lens unit and the imaging sensor chip, wherein a region between the lens unit and the imaging sensor chip is isolated from an external gaseous region.

11. The image apparatus according to Claim 10, wherein the lens unit includes at least a first lens element and a second lens element, and wherein the light receiving area includes at least a first light receiving region and a second light receiving region.

12. The image apparatus according to Claim 11, wherein, in use, a portion of a first light beam passing through the first lens element is incident upon the first light receiving region, and a portion of a second light beam passing through the second lens element is incident upon the second light receiving region.

13. The image apparatus according to Claim 12, further comprising a color filter layer, wherein the color filter layer includes at least a first color filter and a second color filter.

14. The image apparatus according to Claim 13, wherein the first color filter is disposed between the first lens element and the first light receiving region, and the second color filter is disposed between the second lens element and the second light receiving region.

15. The image apparatus according to Claim 14, wherein the first color filter permits light of a first wavelength therethrough, and the second color filter permits light of a second wavelength therethrough, wherein the first and second wavelengths are not equal.

16. A method of manufacturing an imaging apparatus, the method comprising:
forming conductive foil patterns on a first side of an insulating sheet so as to form a wiring board;
bonding a holding module to a second side of the insulating sheet, wherein the first side is opposite the second side;
aligning the conductive foil patterns with conductive bumps provided on an imaging sensor chip;
bonding the imaging sensor chip to the wiring board;
inverting the bonded holding module, the wiring board and the imaging sensor chip;
bonding a transparent module to the holding module, wherein the transparent module includes a lens unit; and
sealing an internal region of the imaging apparatus, wherein the internal region includes a light receiving area of the imaging sensor chip.

17. The method according to Claim 16, further comprising:
forming an aperture layer on the side of the transparent module opposite the side bonded to the holding module.

18. The method according to Claim 17, further comprising:
adjusting the focus and tilt of the lens unit prior to bonding the transparent module to the holding module.

19. The method according to Claim 18, further comprising:
sealing the internal region of the imaging apparatus, wherein the internal region is defined by the holding module, the imaging sensor chip, and the transparent module.
